# EUROPÄISCHE PATENTSCHRIFT

(11) **EP 2 160 774 B1**
(45) Veröffentlichungstag und Bekanntmachung des Hinweises auf die Patenterteilung: **17.11.2010**
(21) Anmeldenummer: 08749661.8
(22) Anmeldetag: 23.04.2008
(51) Int. Cl.: H01L 41/09, H01L 41/053

(54) **ELEKTROMECHANISCHER MOTOR, INSBESONDERE PIEZOELEKTRISCHER MIKROSCHRITTANTRIEB**
ELECTROMECHANICAL MOTOR, ESPECIALLY PIEZOELECTRIC MICROSTEPPER DRIVE
MOTEUR ÉLECTROMÉCANIQUE, NOTAMMENT MOTEUR PAS À PAS PIÉZOÉLECTRIQUE

(30) Priorität: 18.05.2007 DE 102007023200
(43) Veröffentlichungstag der Anmeldung: 10.03.2010
(73) Patentinhaber: Continental Automotive GmbH, 30165 Hannover (DE)
(72) Erfinder: BLUME, Heinrich-Jochen, 64291 Darmstadt (DE); GOTTLIEB, Bernhard, 81739 München (DE); KAPPEL, Andreas, 85649 Brunnthal (DE); KISSEL, Robert Wolfgang, 63329 Egelsbach (DE); MITTENBÜHLER, Karl-Heinz, 64347 Griesheim (DE); SCHWEBEL, Tim, 80337 München (DE); WALLENHAUER, Carsten, 01987 Schwarzheide (DE)
(86) Internationale Anmeldenummer: PCT/EP2008/054890
(87) Internationale Veröffentlichungsnummer: WO 2008/141883

(56) Entgegenhaltungen:
- EP-A- 1 098 429
- DE-A1-102005 024 317
- DE-A1-102006 027 406
- DE-A1-102006 044 000
- US-A- 5 079 471

## Beschreibung

Die vorliegende Erfindung betrifft einen elektromechanischen Motor, insbesondere einen piezoelektrischen Stellantrieb.

Das Cockpit eines Kraftfahrzeugs versucht ein optimales Zusammenspiel von Design und Technik zu realisieren. Im Blickfeld des Fahrers liegen dabei verschiedene Zeigerinstrumente. Diese Zeigerinstrumente müssen sowohl unterschiedlichen technischen Anforderungen genügen als auch einen konkurrenzfähigen Preis für die Massenproduktion von Kraftfahrzeugen besitzen. Ein Beispiel für ein derartiges Zeigerinstrument ist das "Messwerk 2000" der Firma Siemens VDO.

Das "Messwerk 2000" basiert auf einem mit einem einstufigen Schneckenradgetriebe untersetzten Schrittmotorantrieb. Der vierpolige Schrittmotor wird durch zwei um 90° im Phasenwinkel zueinander phasenverschobene sinusartige Spulenstromverläufe als Funktion der Zeit angesteuert. Das Vorzeichen der Phasenverschiebung bestimmt die Drehrichtung und die Frequenz die Drehgeschwindigkeit der Motorwelle. Im Rahmen einer vollen Periode von 360° der sinusartigen Stromverläufe können bis zu 128 Zwischenstufen reproduzierbar eingestellt werden. Die Nutzung dieser Zwischenstufen wird als Mikroschrittbetrieb bezeichnet.

Ein kompletter Stellantrieb "Messwerk 2000", der den oben charakterisierten Schrittmotor beinhaltet, besteht aus zwölf Einzelteilen. Der Schrittmotor selbst setzt sich aus zwei Spulen mit einem gemeinsamen Statorblech und einem Permanentmagnetrotor zusammen. Hinsichtlich der Bauteilkosten schlagen die Spulen und der Permanentmagnet am stärksten zu Buche. Entscheidend für den Preis sind neben den Materialkosten ebenfalls die Herstellungskosten, die näherungsweise proportional zur Anzahl der Komponenten des Stellantriebs zunehmen. Aus der EP 1 098 429 B1 ist ein nach einem neuen Motorprinzip, das heißt ohne rotierende Spulen, arbeitender elektromechanischer Motor bekannt, bei dem während des Betriebs durch eine zeitlich versetzte Betätigung von mindestens zwei elektromechanischen Antriebselementen ein Antriebsring umlaufend verschoben wird, so dass durch einen unmittelbaren Kraftübertrag vom Antriebsring auf die - insbesondere innerhalb des Antriebsrings befindliche - Welle diese gedreht wird. Die umlaufenden Verschiebebewegungen des Antriebsrings können durch einen z. B. piezoelektrisch, magnetostriktiv, elektrostriktiv oder elektrodynamisch angetriebenen Aktor hervorgerufen werden, so dass ein hinsichtlich der Materialkosten und Herstellungskosten besser für die Massenproduktion geeigneter Stellantrieb resultiert. Die Piezoaktoren werden so am Antriebsring angebracht, dass ihr jeweiliger Hub radial auf den Antriebsring wirkt, wobei gegebenenfalls noch weitere Maßnahmen ergriffen werden, um eine möglichst symmetrische Krafteinleitung auf den Antriebsring zu erreichen.

Unter den zuletzt genannten technischen Umständen ergibt sich zwar ein hinsichtlich der Funktion optimierter Antrieb mit besten Gleichlaufeigenschaften (Konstanz der Drehgeschwindigkeit unabhängig von der momentanen Stellung der Welle) ohne Drehmomentschwankungen. Insbesondere die Längserstreckung und die radiale Anordnung der Biegeaktoren bringt es dabei jedoch mit sich, dass die ebenen Antriebsvarianten einen erheblichen Platzbedarf in der Ebene erfordern und zumeist wenig kompakt erscheinen. Kompakte ebene Antriebe werden aber aufgrund der in Cockpitinstrumenten vorgegebenen sehr beengten Bauraumverhältnisse dringend benötigt.

Die Aufgabe der vorliegenden Erfindung besteht darin, einen hinsichtlich Teilezahl, Fertigungsaufwand, Bauraumbedarf und Funktionalität optimierten Schrittantrieb, insbesondere einen Kleinstellantrieb für Messwerke von Cockpitinstrumenten, bereitzustellen.

Diese Aufgabe wird durch einen elektromechanischen Motor, insbesondere einen piezoelektrischen Mikroschrittmotor, gemäß Patentanspruch 1 gelöst. Vorteilhafte Ausgestaltungen und Weiterentwicklungen der vorliegenden Erfindung gehen aus der folgenden Beschreibung, den Zeichnungen und den abhängigen Ansprüchen hervor.

Der erfindungsgemäße elektromechanische Schrittantrieb weist die folgenden Merkmale auf:
Zwei elektromechanische, vorzugsweise piezoelektrische, Antriebselemente (Aktoren), die annähernd senkrecht zueinander ausgerichtete Wirkrichtungen aufweisen, und eine in einem Antriebsring derart drehbar gelagerte Welle, dass der Antriebsring durch eine Auslenkung der piezoelektrischen Antriebselemente in die jeweilige Wirkrichtung zu einer unmittelbar auf die Welle übertragbaren Verschiebebewegung anregbar ist, so dass die Welle im Antriebsring abrollt und dadurch rotiert. Weiterhin sind am Antriebsring zwei bezüglich der beiden Wirkrichtungen diagonal gegenüberliegende Befestigungen vorgesehen, anhand derer der Antriebsring über jeweils ein annähernd rechtwinkliges Winkelelement, dessen Schenkel jeweils zu ihren beiden Enden hin jeweils ein Gelenk aufweisen, an jeweils einem Fixierelement flexibel aufgehängt ist, wobei außerdem die Winkelelemente, deren vier Schenkel sich um den Antriebsring herum zu einer annähernd rechtwinklig ausgebildeten, parallel zu den beiden Wirkrichtungen ausgerichteten Umrahmung ergänzen, so angeordnet sind, dass die jeweilige Befestigung mittels des jeweiligen Winkelelements an ein ihr in der Umrahmung diagonal gegenüberliegend angeordnetes Fixierelement angebunden ist. Dabei weisen die Winkelelemente jeweils ein Eckelement auf, deren Abstand zueinander mittels einer Zwangsmaßnahme konstant gehalten ist, so dass der Antriebsring verschiebbar, aber nicht tordierbar aufgehängt ist.

Die erfindungsgemäße Ringaufhängung mit zwei abgeknickten Aufhängungselementen (Winkelelemente), die am Antriebsring diagonal gegenüberliegend angreifen und die jeweilige Befestigung an einem ihr diagonal gegenüberliegenden Punkt fixieren, wobei die beiden Winkelelemente drehflügelartig mit gleicher Drehrichtung um den Antriebsring herum angeordnet sind, weist insoweit eine (180°) Drehsymmetrie auf und verwirklicht aufgrund der spezifischen, gelenkigen Anbindung ihrer Elemente bzw. Teile relativ zueinander eine 'Diagonalkinematik'. Bei dieser muss, im Gegensatz zum Stand der Technik, nicht mehr auf die radiale Krafteinleitung der durch die Biegeaktoren bereitgestellten Kräfte in den Antriebsring bezüglich des Mittelpunktes der Ringbohrung geachtet werden, da das durch die nichtradiale, exzentrische Krafteinleitung hervorgerufene Drehmoment auf den Antriebsring - aufgrund der den Abstand der Eckelemente betreffende Zwangsmaßnahme, durch die eine Unterdrückung der Torsionsfreiheitsgrade der flexiblen Ringaufhängung erreicht wird - von der Ringaufhängung im Wesentlichen torsionsfrei aufgenommen wird. Dies eröffnet die Möglichkeit einer platzsparenden Anordnung der Antriebselemente, insbesondere entlang der Innen- und/oder Außenseiten der Schenkel der Winkelelemente, also beispielsweise parallel zu zwei über Eck angeordneten Seiten eines (nach außen) rechtwinkligen Antriebsringes. Dadurch ist ein sehr kompakter, bauraumsparender Aufbau des Schrittantriebes realisierbar. Der erfindungsgemäße Schrittantrieb zeichnet sich weiterhin durch eine sehr geringe Anzahl von einfachen Bauteilen aus, so dass der für die Massenproduktion besonders geeignet ist. Ferner wird eine aufgrund unterschiedlicher Wärmedehnung von Kunststoff und Aktor auftretende thermische Verstimmung des Antriebs konstruktiv sicher abgefangen. Durch Formschluß, z. B. mittels einer zwischen Antriebsring und Welle ausgebildeten Verzahnung, wird eine sehr hohe Stellgenauigkeit des erfindungsgemäßen Antriebs im rein gesteuerten Betrieb erreicht, ohne Sensoren und einen Regelkreis in Anspruch nehmen zu müssen.

Erfindungsgemäß wird - zugunsten der Optimierung der Kompaktheit - keine unbedingt vollkommene symmetrische Krafteinleitung auf den Antriebsring angestrebt. Die sich hinsichtlich der Funktion daraus gegebenenfalls ergebenden Konsequenzen, z. B. leichte Gleichlauf- und Drehmomentschwankungen, können durch weitere Maßnahmen soweit reduziert werden, dass die Kundenspezifikationen weiterhin eingehalten werden. Insbesondere können kleine Drehmomente durch eine den reinen Sinusverlauf modulierende Ansteuerung der Antriebselemente ausgeglichen werden.

Bei einer besonders vorteilhaften Ausführungsform der Erfindung ist die Zwangsmaßnahme zur Sicherung der erforderlichen Torsionssteifigkeit der Ringaufhängung dadurch realisiert, dass parallel zur Ebene des Antriebsringes mindestens ein als Stab oder Bügel ausgebildeter Abstandshalter angeordnet ist, dessen Enden starr mit den Eckelementen der Winkelelemente verbunden sind. Die Festlegung des Abstands der beiden Eckelemente der Winkelelemente durch den Abstandshalter hat zur Folge, dass die Ringaufhängung relativ zu den beiden Wirkrichtungen leicht (d. h. nahezu kräftefrei) scheren kann. Einer Torsion hingegen setzt die so ausgebildete Ringaufhängung mit Diagonalkinematik sehr hohen Widerstand entgegen.

Bei einer konstruktiv einfachen beziehungsweise leicht herstellbaren Weiterbildung dieser Ausführungsform weisen die Eckelemente mindestens einseitig jeweils einen senkrecht zur Ebene des Antriebsringes angeordneten Zapfen auf, und der Abstandshalter, dessen Enden jeweils mittels einer Durchgangsbohrung mit dem jeweiligen Zapfen des jeweiligen Eckelementes verbindbar sind, weist eine Ausnehmung für die berührungsfreie Durchführung der vom Antriebsring angetriebenen Welle auf.

Zur einfachen Realisierung der Gelenkigkeit der diagonalen Ringaufhängung sind die Schenkel der Winkelelemente jeweils mittels jeweils eines Festkörpergelenks an die Befestigung, das Eckelement und an das Fixierelement angebunden. Die Festkörpergelenke können jeweils durch eine Verjüngung des Querschnittes der Schenkel der Winkelelemente in einem kurzen Abschnitt gebildet sein, was insbesondere fertigungstechnisch von Vorteil ist.

Mit Blick auf die zu implementierende Diagonalkinematik ist es günstig, die Fixierelemente in diagonal gegenüberliegenden Ecken eines annähernd rechteckigen mechanisch steifen Rahmens zu befestigen. In einer Weiterbildung ist der Rahmen als ein Gehäuseteil des Schrittantriebs ausgebildet.

Die zwei elektromechanischen Antriebselemente können besonders vorteilhaft als Biegewandler, vorzugsweise piezoelektrische Biegewandler, ausgestaltet sein.

Derartige Festkörper-Biegeaktoren auf Basis piezoelektrischer Keramikwerkstoffe werden in verschiedenartigen Bauformen seit vielen Jahren vielseitig in der Industrie eingesetzt. Sie zeichnen sich durch eine kleine Bauform, einen niedrigen Energiebedarf und eine hohe Zuverlässigkeit aus. So zeigt beispielsweise ein piezoelektrischer Biegeaktor eine Lebensdauer von mindestens 10⁹ Zyklen im industriellen Umfeld. Die in einem Kleinstellantrieb für beispielsweise Zeigerinstrumente zum Einsatz kommenden Biegewandler werden typischerweise so dimensioniert, dass sie an ihrem bewegten Ende eine freie Auslenkung im Bereich von ca. 0,2 mm bis 2 mm aufweisen. Zudem wird im Fall der Auslenkungsblockierung des frei bewegbaren Endes des Biegewandlers eine Blockierkraft im Bereich von 0,5 N bis 2 N erreicht. Die näherungsweise geradlinige Auslenkung der Biegewandler erfolgt jeweils transversal bezogen auf ihre größte Längserstreckung. Die Richtung der Auslenkung, die der Wirkrichtung des Biegewandlers entspricht, ist somit annähernd orthogonal zur Längsachse des Biegewandlers.

Eine besonders kompakte Variante des erfindungsgemäßen Schrittantriebs ergibt sich durch eine Anordnung, bei der die Biegewandler jeweils über einen an ihr bewegtes Ende angekoppelten, annähernd parallel zur Wirkrichtung des zugehörigen Biegewandlers angeordneten Zug-Druckstab an den Antriebsring angelenkt sind, wobei die Zug-Druckstäbe jeweils zu jedem ihrer beiden Enden hin ein Festkörpergelenk aufweisen. Dabei sind jeweils ein Biegewandler und der zugehörige Zug-Druckstab über Eck entlang zweier Seiten oder - bei einem nicht rechtwinklig ausgebildeten Antriebsring - entlang zweier Hälften des Antriebsringes angeordnet. Durch diese scherflexible Anlenkung der beiden elektromechanischen, vorzugsweise piezoelektrischen, Antriebselemente an den Antriebsring ergibt sich der Vorteil, dass ihre Bewegungsrichtungen entkoppelt voneinander sind, so dass sich die Antriebselemente in ihrer Bewegung nicht oder vernachlässigbar gering behindern. Bei der Krafteinleitung treten also keine Verlustenergien auf. Außerdem ist die Anordnung beziehungsweise Anlenkung der Biegewandler gemäß dieser Ausführungsform sehr platzsparend.

Gemäß einer Weiterbildung der Ausführungsformen mit Biegewandlern ist es vorteilhaft, den Antriebsring, die Winkelelemente und die Fixierelemente als ein einstückig in Kunststoffspritzgusstechnik gefertigtes Antriebsmodul auszubilden, wobei die Biegewandler mit in das Antriebsmodul eingespritzt sind. Die Realisierung des Antriebsmoduls in Kunststoffspritzgusstechnik ist einfach und kostengünstig, wobei durch die Einbeziehung der Biegeaktoren in den Einspritz- Arbeitsgang die Anzahl der Fertigungsschritte noch weiter reduziert wird.

Zur steifen Lagerung des Antriebsmoduls bzw. zur drehbaren Lagerung der zugehörigen Welle ist es vorteilhaft, ein annähernd quaderförmiges Gehäuse mit einem Bodenelement und einem Deckel vorzusehen, wobei im Bodenelement ein zentraler Lagerblock mit einer Anlagefläche und mit einer ersten Lagerbohrung und im Deckel eine zweite Lagerbohrung für die Welle vorgesehen ist, und wobei die Fixierelemente derart in einer Gehäuseecke angeordnet und dort befestigt oder integriert sind, dass die mindestens eine zylindrische Abrollfläche der Welle in einer zugehörigen Abrollfläche einer Ringbohrung des Antriebsringes abrollen kann.

Die bevorzugten Ausführungsformen der vorliegenden Erfindung werden unter Bezugnahme auf die begleitende Zeichnung näher erläutert. Es zeigen:
Fig. 1A und 1B eine Ausführungsform eines in einem Gehäuserahmen fixierten Antriebsmoduls für den erfindungsgemäßen Schrittantrieb jeweils in Draufsicht bzw. in perspektivischer Ansicht,
Fig. 2A und 2B, jeweils in gleicher Ansicht wie Fig. 1, das dortige Antriebsmodul, jedoch mit eingesetzten Biegeaktoren und Abstandhaltern,
Fig. 3 eine Draufsicht auf einen Abstandhalter gemäß Figur 2,
Fig. 4A und 4B, jeweils in gleicher Ansicht wie Fig. 1, ein Gehäuse-Bodenelement zur Lagerung der Welle und des Antriebsmoduls,
Fig. 5A und 5B, jeweils in gleicher Ansicht wie Fig. 1, einen zum Gehäuse gemäß Figur 4 passenden Deckel,
Fig. 6A und 6B, jeweils in gleicher Ansicht wie Fig. 1, einen Teilzusammenbau des gehäusten erfindungsgemäßen Schrittantriebs,
Fig. 7A und 7B, jeweils in gleicher Ansicht wie Fig. 1, eine Ansicht einer Bügelfeder,
Fig. 8A und 8B, jeweils in gleicher Ansicht wie Fig. 1, eine Welle für den erfindungsgemäßen Schrittantrieb,
Fig. 9 einen axialen Querschnitt entlang der z-Achse durch den gehäusten Antrieb im zusammengebauten Zustand.

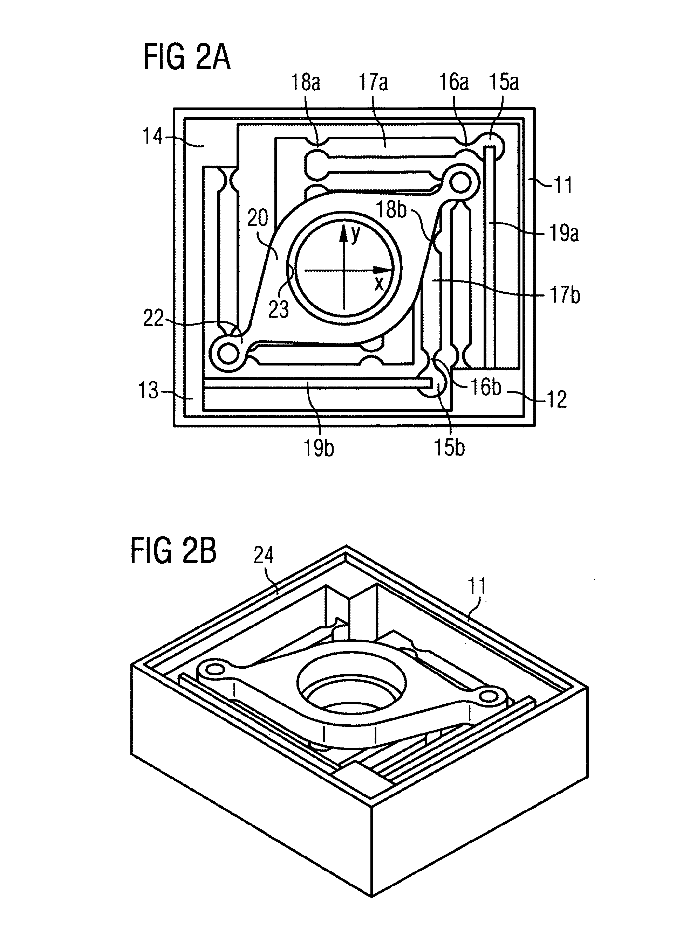

Erfindungsgemäß wird ein piezoelektrischer Schrittmotor vorgestellt, der es erlaubt, durch eine Überlagerung geeigneter periodischer Linearbewegungen der Biegewandler eine kontinuierliche und gleichförmige Rotation zu erzeugen. Zu diesem Zweck werden die Biegewandler 19a, 19b, vgl. Figur 2, mittels einer eine Verschiebbarkeit beziehungsweise Scherflexibilität in der x-y-Ebene gewährleistenden Ringaufhängung, in der die erfindungsgemäße Diagonalkinematik implementiert ist, derart an einen flachen Antriebsring 1 angekoppelt, dass dieser entlang der zueinander senkrechten Wirkrichtungen x und y der Biegewandler 19a, 19b (vgl. Figur 2) translatierbar ist. Die aus den (im Rahmen 11 integrierbaren) Fixierelementen 12, 14 zusammen mit dem Antriebsring 1, den Winkelelementen 36a, 36b, den Zug-Druckstäben 17a, 17b und, gegebenenfalls, den integrierten Biegewandlern 19a, 19b, gebildete Einheit wird im Folgenden als 'Antriebsmodul' bezeichnet. Das Antriebsmodul ist mit Hilfe einer Spritzgusstechnik aus Polyethylen, Spritzguss-Kunststoff, POM oder aus anderen geeigneten Werkstoffen herstellbar.

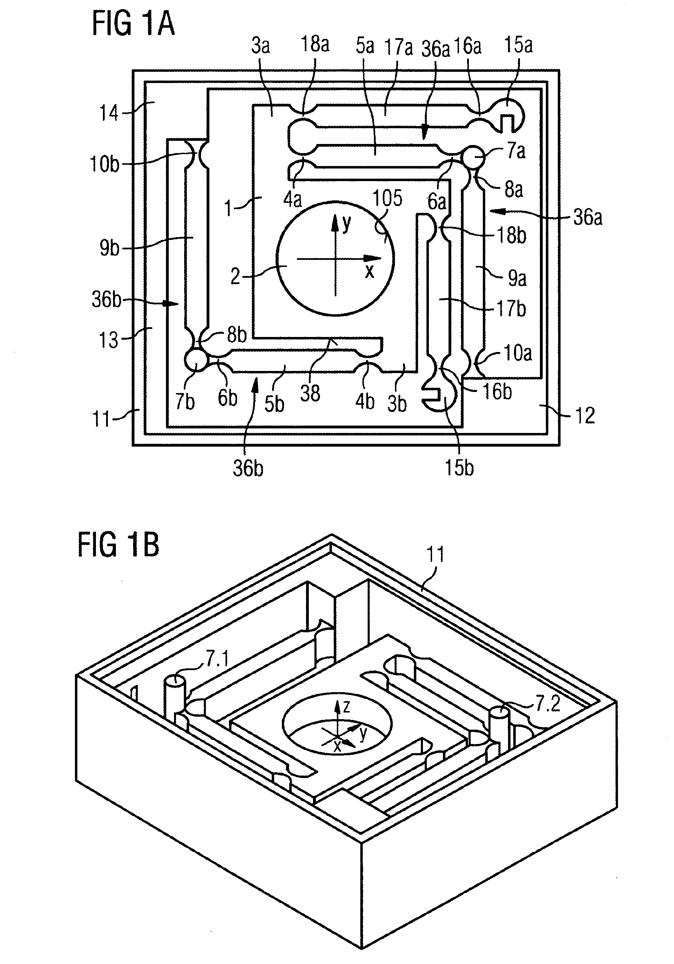

Figur 1 zeigt das Antriebsmodul in der Draufsicht und in der Perspektive. Es besteht zunächst aus einem Antriebsring 1, der eine zylindrische Ringbohrung 2 enthält, deren Achse z. B. mit der z-Achse eines kartesischen Koordinatensystems zusammenfällt, dessen x-y-Ebene sich parallel zur Blattebene erstreckt. Der Antriebsring 1 ist beispielhalber rechtwinklig ausgebildet und mit seinen (Außen)kanten beziehungsweise Seiten 38 parallel zu den beiden senkrechten Wirkrichtungen der Antriebselemente 19a, 19b ausgerichtet. Am Antriebsring 1 sind an diagonal gegenüberliegenden Positionen Befestigungen 3a, 3b vorgesehen. Anhand derer ist der Antriebsring 1 über jeweils eine sequentielle Anordnung von Funktionselementen bestehend aus: einem Festkörpergelenk 4a, 4b, einem ersten Schenkel (Druck-Zugstab) 5a, 5b, einem Festkörpergelenk 6a, 6b, einem Eckelement 7a, 7b, einem Festkörpergelenk 8a, 8b, einem zweiten Schenkel (Druck-Zugstab) 9a, 9b und einem weiteren Festkörpergelenk 10a, 10b in einem mechanisch hinreichend steifen Rahmen 11 flexibel aufgehängt. Diese beiden sequentiellen Anordnungen werden im Folgenden jeweils auch als Winkelelement 36a beziehungsweise Winkelelement 36b bezeichnet.

Der Rahmen 11 bildet in diesem Ausführungsbeispiel gleichzeitig einen Teil des Antriebsgehäuses und kann gegebenenfalls Verstärkungen 12, 13, 14 aufweisen (z.B. in den Ecken und Kanten). Der Rahmen 11 kann zur Befestigung des Stellantriebs, insbesondere der Fixierelemente 12, 14 dienen und wird daher als raumfest angenommen. Die Schenkel (Druck-Zugstäbe) 5a, 9a bzw. 5b, 9b sind in etwa orthogonal zueinander und in etwa parallel zur x-Achse (z.B. Stäbe 5a, 5b) bzw. y-Achse (z.B. Stäbe 9a, 9b) des oben definierten Koordinatensystems angeordnet. Die Schenkel 5a, 5b, 9a, 9b werden mechanisch hinreichend steif gegenüber den im Betrieb auftretenden Zug-Druckkräften und Querkräften (Biegung) ausgeführt, so dass sie in sehr guter Näherung als Starrkörper betrachtet werden können. Aufgrund der geeignet ausgeführten Festkörpergelenke 4a, 4b, 6a, 6b, 8a, 8b, 10a, 10b bekommt die Ringaufhängung ihre Flexibilität im Bezug auf Verschiebungen des Ringes in der x-y Ebene und Torsion des Ringes bezüglich der z-Achse relativ zum Rahmen 11. Festkörpergelenke ermöglichen, wie gewöhnliche Gelenke (allerdings nur innerhalb eines begrenzten Winkelbereiches, dafür aber spielfrei) eine nahezu ungehinderte Rotation der angeschlossenen Elemente relativ zueinander. Ihre Funktion basiert auf dem Biegeprinzip. Erreicht wird die lokale Biegung durch eine gezielte Verringerung des Stabquerschnittes in einem kurzen Abschnitt. Der reduzierte Stabquerschnitt führt zu einer stark reduzierten Biegesteifigkeit. Da die Querschnittsverjüngung sehr lokalisiert ist, wird die axiale Federrate (Steifigkeit) des jeweiligen Stabes aber kaum verringert.

Die erfindungsgemäße Ringaufhängung weist folgende bemerkenswerte Eigenschaften und Funktionen auf:
Wird der Antriebsring 1 z. B. in x-Richtung um eine Strecke dx relativ zum Rahmen 11 verschoben, die klein verglichen mit einer typischen Stablänge 1 ist, so werden die Stäbe 5a, 5b und damit auch die Eckelemente 7a, 7b im Gleichlauf mitverschoben, ohne dass sich ihre Lage relativ zum Antriebsring 1 verändert, wohingegen die Stäbe 9a, 9b geringfügig um den Winkel ϕ ≈ dx/l « 1 rotiert werden. Aufgrund der Kleinheit des Winkels ϕ bleiben die y-Koordinaten der Eckelemente 7a, 7b während der Verschiebung in sehr guter Näherung unverändert. Daraus folgt, dass sich der Abstand der Eckelemente 7a, 7b relativ zueinander während der Verschiebung in x-Richtung nicht bzw. nur vernachlässigbar wenig verändert. Eine analoge Betrachtung gilt für eine Verschiebung des Antriebsringes 1 in y-Richtung um eine Strecke dy, die klein gegenüber einer typischen Stablänge ist.

Als wichtiges Resultat ergibt sich, dass ebene Verschiebungen des Antriebsringes 1 in der x-y -Ebene den Abstand der Eckelemente 7a, 7b unverändert lassen. Die mit den Verschiebungen einhergehenden geringfügigen Stabrotationen werden von den Festkörpergelenken 4a, 4b, 6a, 6b, 8a, 8b, 10a, 10b leicht aufgenommen.

Wird der Antriebsring 1 um die z-Achse z.B. im Uhrzeigersinn um einen kleinen Winkel rotiert, so ändern sich die x-Koordinaten und die y-Koordinaten der Befestigungen 3a, 3b relativ zueinander und relativ zum Rahmen 11 gegenläufig. Ändern sich, verursacht durch die Rotation, die x- und y-Koordinaten der Befestigung 3a um die Beträge dx und dy, so ändern sich gleichzeitig die x- und y-Koordinaten einer im gleichen Abstand von der Drehachse diagonal gegenüber lokalisierten Befestigung 3b um die Beträge -dx bzw. -dy. Die gegenläufigen Verschiebungen der Befestigungen 3a, 3b in x-Richtung relativ zum Rahmen 11 werden durch geringfügige Rotationen der Stäbe 9a, 9b aufgenommen. Die Eckelemente 7a, 7b vollziehen die gegenläufige Verschiebung der Befestigungen in x-Richtung mit, da sie bezüglich der x-Richtung starr an den Ring 1 gekoppelt sind, aber leicht drehbar hinsichtlich des Rahmens 11.

Die gegenläufigen Verschiebungen der Befestigungen 3a, 3b in y-Richtung relativ zum Rahmen 11 werden durch geringfügige Rotationen der Stäbe 5a, 5b aufgenommen. Die Eckelemente 7a, 7b vollziehen die gegenläufige y-Verschiebung der Befestigungen 3a, 3b nicht mit, da sie bezüglich der y-Richtung leicht drehbar an den Antriebsring 1, aber starr an den Rahmen 11 über die Stäbe 9a, 9b gekoppelt sind.

Als weiteres wichtiges Resultat ergibt sich, dass Rotationen des Antriebsringes 1 bezüglich der z-Achse den Abstand der Eckelemente 7a, 7b ändern. Die mit den Ringrotationen einhergehenden geringfügigen Stabrotationen werden von den Festkörpergelenken 4a, 4b, 6a, 6b, 8a, 8b, 10a, 10b leicht aufgenommen.

Zur Bildung einer Ringaufhängung, die ungehindert Verschiebungen des Antriebsringes 1 in der x-y Ebene ermöglicht um Wege, die klein sind verglichen mit einer typischen Stablänge, aber einer Drehung des Ringes 1 um die z-Achse sehr hohen Widerstand entgegensetzt, ist es erforderlich, den Abstand der Eckelemente 7a, 7b durch eine Zwangsmaßnahme, z.B. einen Stab oder Bügel konstant zu halten. Zur Befestigung eines geeigneten Abstandhalters sind die Eckelemente 7a, 7b, wie in Figur 1B erkennbar, mit jeweils ein oder zwei Zapfen 7.1, 7.2 ober- und unterhalb der Zeichnungsebene ausgestattet.

Die derart gebildete Struktur der Ringaufhängung, die hier als Diagonalkinematik bezeichnet wird, verhält sich außerordentlich torsionssteif. Infolgedessen muss erfindungsgemäß nicht mehr auf die radiale Krafteinleitung der durch die Aktoren bereitgestellten Kräfte in den Antriebsring 1 bezüglich des Mittelpunktes der Ringbohrung 2 geachtet werden, da das durch eine, mehr oder weniger exzentrische, nichtradiale Krafteinleitung hervorgerufene Drehmoment auf den Antriebsring 1 durch die hier beschriebene Diagonalkinematik torsionsfrei aufgenommen und an den Rahmen 11 abgeleitet wird.

Zur Anbindung der Antriebselemente in Form streifenförmiger Festkörperbiegeaktoren sind geeignet ausgestaltete, in Figur 1A erkennbare, Aufnahmekörper 15a, 15b für deren bewegte Enden vorgesehen, die jeweils über ein Festkörpergelenk 16a, 16b, einen Druck-Zugstab 17a, 17b und ein weiteres Festkörpergelenk 18a, 18b am Antriebsring 1 befestigt werden. Die verursachten Auslenkungen in der Ringaufhängung bewegen sich im Bereich von nur ca. hundert Mikrometer.

Figur 2 zeigt das Antriebsmodul mit eingesetzten Festkörper-biegeaktoren 19a, 19b, die im Folgenden nur kurz Aktor genannt werden, und zwei Abstandhaltern 20. In der dargestellten beispielhaften Konfiguration sind die Aktoren 19a, 19b an ihrem ruhenden Ende mechanisch steif im Rahmen 11 befestigt und in etwa orthogonal zueinander angeordnet. Die Steifigkeit der Anbindung der Aktoren 19a, 19b an den Rahmen 11 kann durch Verstärkungen bzw. Fixierelemente 12, 13 des Rahmens 11 erhöht werden. Zudem können im Rahmen 11 und insbesondere in den Verstärkungen 12, 13 hier nicht gezeigte Maßnahmen zur elektrischen Kontaktierung der Aktoren 19a, 19b an ihrem ruhenden Ende in Form von Klemm- oder Druckfederkontakten usw. vorgesehen sein.

Wahlweise können die Aktoren 19a, 19b stattdessen auch in ihren bewegten Abschnitten oder ihrem bewegten Ende elektrisch kontaktiert sein.

Wird ein Aktor 19a, 19b elektrisch angesteuert, so vollzieht er eine Biegebewegung, wobei sein bewegtes Ende im Wesentlichen eine Bewegung senkrecht zu seiner Längserstreckung ausführt. Daher vollzieht bei elektrischer Ansteuerung das bewegte Ende von Aktor 19a im Wesentlichen eine Bewegung in x-Richtung und das bewegte Ende von Aktor 19b im Wesentlichen eine Bewegung in y-Richtung.

Die Bewegungsrichtung der Aktoren 19a, 19b wird auch mit Wirkrichtung bezeichnet.

Das bewegte Ende der Aktoren 19a, 19b wird von den Aufnahmekörpern 15a, 15b umfasst und mechanisch steif und spielfrei gehalten, so dass der Aufnahmekörper vom Aktor erzeugte Druck- und Zugkräfte bzw. Druck- und Zugbewegungen aufnehmen und über die Festkörpergelenke 16a, 16b auf die in etwa parallel zur Wirkrichtung der zugehörigen Aktoren ausgerichteten Druck-Zugstäbe 17a, 17b und von dort über die angeschlossenen Festkörpergelenke 18a, 18b auf den Antriebsring 1 übertragen kann. Die sequentielle Anordnung von Aufnahmekörper, Festkörpergelenk, Druck-Zugstab, der in etwa parallel zur jeweiligen Aktorwirkrichtung ausgerichtet ist, Festkörpergelenk und Antriebsring 1 bietet den Vorteil, dass prinzipbedingt nur die Kraft bzw. Auslenkung in Wirkrichtung des Aktors zwischen Aktor und Antriebsring übertragen werden kann und keine andere. Daher können die beiden in etwa orthogonal angeordneten Aktoren 19a, 19b völlig unabhängig voneinander auf den Antriebsring 1 wirken, ohne sich gegenseitig zu beeinflussen. Die Aktoren müssen also insbesondere nicht gegen die vergleichsweise hohe mechanische Steifigkeit des jeweils anderen Biegewandlers arbeiten. Die Bewegungen der Biegewandler 19a, 19b sind also entkoppelt.

Wird ein Biegeaktor elektrisch angesteuert, so biegt er sich näherungsweise in Form eines Kreisbogens, wodurch sich die Tangentensteigung der Biegelinie am bewegten Ende des Aktors ändert. Diese Art der "Drehbewegung" wird durch die Festkörpergelenke 16a, 16b, 18a, 18b sicher abgefangen. Ebenso wird eine Änderung der Aktorlänge relativ zum Antriebsmodul (z.B. durch unterschiedliche thermische Dehnung der Diagonalkinematik und des Aktormaterials) durch die Zug-Druckstabkopplung 17a, 17b mit Festkörpergelenken 16a, 16b, 18a, 18b sicher abgefangen, indem die Stäbe 17a, 17b minimal rotiert werden, ohne dass hierdurch deren Kraft- bzw. Wegübertragungsfunktion beeinträchtigt wird.

Die Torsionssteifigkeit der Ringaufhängung wird durch den Abstandhalter 20 gewährleistet, der z. B. durch Aufpressen geeignet gestalteter Durchgangsbohrungen 21 auf die Zapfen 7.1, 7.2 der Eckelemente 7a, 7b mit diesen mechanisch steif verbunden wird.

Zusammenfassend ist festzuhalten, dass die Biegeaktoren 19a und 19b den Antriebsring 1 völlig unabhängig voneinander in x- bzw. y-Richtung relativ zu den Fixierelementen 12 und 14 bewegen. Eine Ringtorsion wird durch die Diagonalkinematik unterbunden.

Im Übrigen besitzt der Gehäuserahmen 11 des Antriebsmoduls an seiner Ober- und Unterseite Umlaufkanten 24 zum positionsgenauen Einsetzen eines Deckels und eines Bodens, wie sie weiter unten noch näher beschrieben werden.

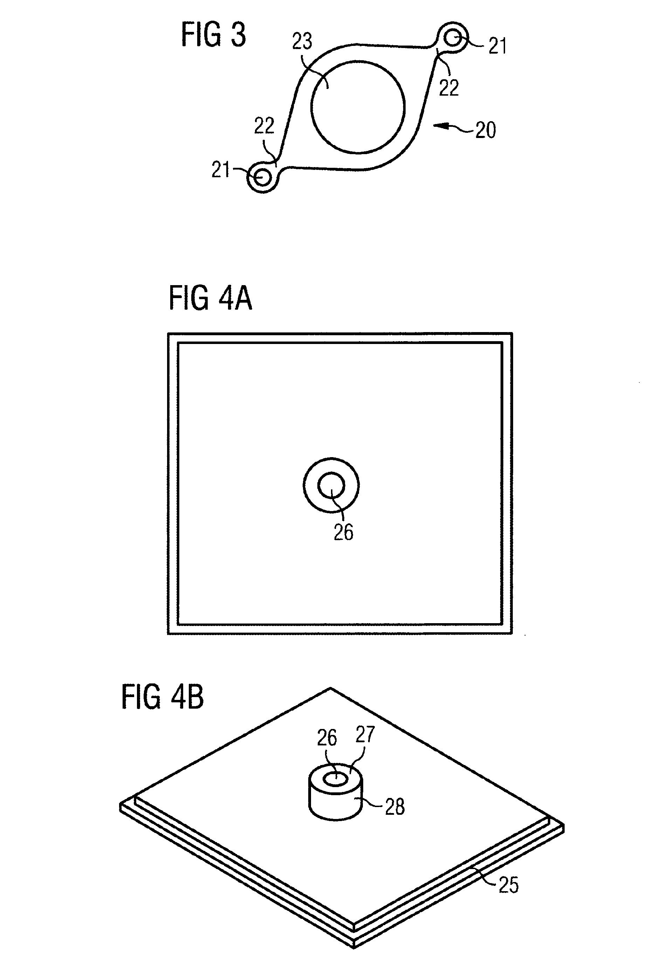

Figur 3 zeigt den Abstandhalter 20 mit zu den Zapfen 7.1, 7.2 der Eckelemente 7a, 7b für eine Pressverbindung geeignet gepassten Durchgangsbohrungen 21. Der Abstandhalter 20 besitzt eine hinreichend hohe Druck-Zugsteifigkeit zwischen den - in den Achsen der Durchgangsbohrungen 21 gelegenen - Krafteinlenkpunkten.

Der Abstandhalter 20 kann optional Festkörpergelenke 22 enthalten um eine mögliche geringfügige Rotation der Eckelemente 7a, 7b nicht zu behindern. Die Ausnehmung 23 dient zur berührungsfreien Durchführung der Welle.

Zur Realisierung des mit dem Antriebsmodul verbundenen diagonalkinematischen Prinzips im Schrittmotor sind des Weiteren eine Welle und eine möglichst spielfreie, aber drehbare Lagerung derselben, sowie eine steife Lagerung des Antriebsmoduls erforderlich:

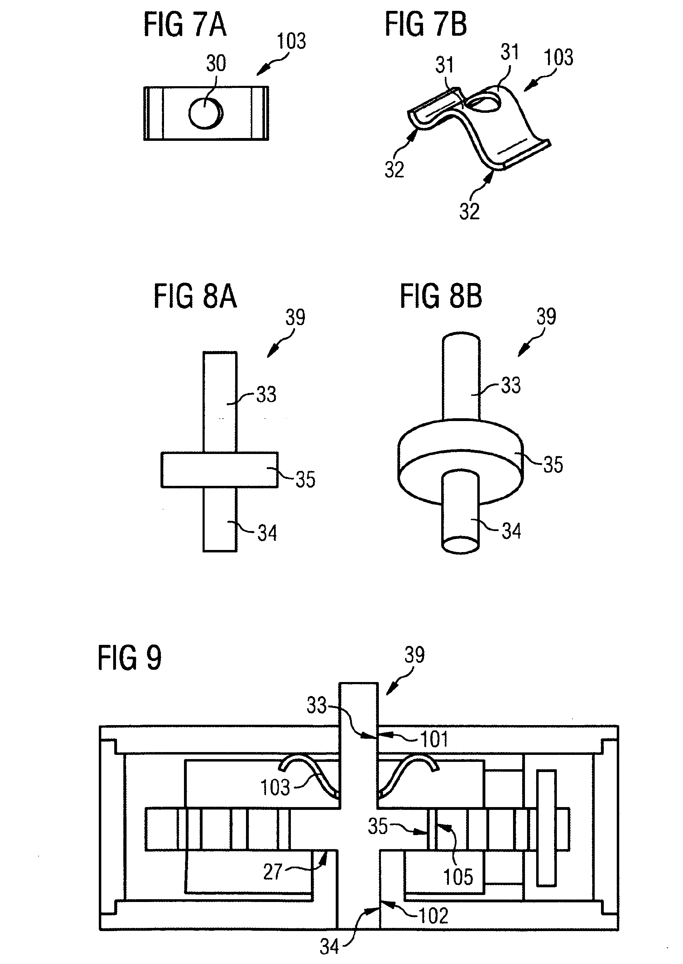

Figur 4 zeigt ein hierfür im Zusammenhang mit dem Gehäuserahmen 11 geeignetes Bodenelement. Es enthält eine zu einer Umlaufkante 24 des Antriebsmoduls gepaarte Umlaufnut 25, die beim Einsetzen des Bodenelementes in das Antriebsmodul gewährleistet, dass die Bohrungsachse einer Lagerbohrung 26 kongruent zur Achse der Ringbohrung 2 des Ringes 1 zu liegen kommt. Der Durchmesser der Lagerbohrung 26 ist zu einer zylindrischen Gleitfläche zur Welle 39, vergleiche Figur 9, gepaart, die zusammen eine erste spielfreie, aber reibungsarme Drehlagerung für die Welle 39 bilden. Die Stirnfläche 27 des zentralen Lagerblocks 28 dient als Anlagefläche für die Welle 39, damit eine Abrollfläche der Welle 39 auf gleicher Höhe mit der Ringbohrung 2 zu liegen kommt.

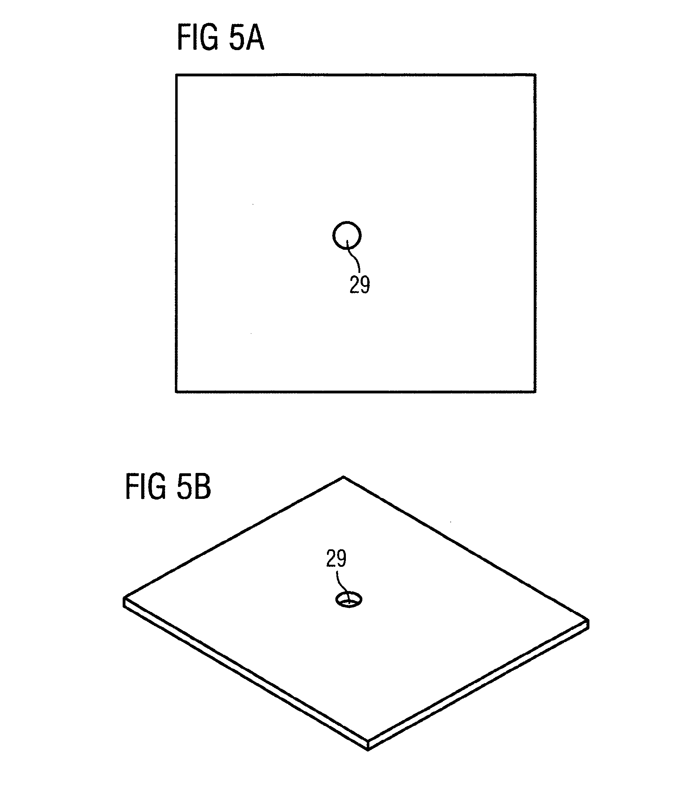

Figur 5 zeigt den zum Gehäuserahmen 11 passenden Deckel, der an seiner Unterseite ebenfalls eine Umlaufnut aufweist, die zu einer Umlaufkante 24 des Antriebsmoduls gepaart ist, so dass beim Einsetzen des Deckels in das Antriebsmodul die Achse einer Lagerbohrung 29 kongruent zur Achse der Ringbohrung 2 zu liegen kommt. Der Durchmesser der Lagerbohrung 29 ist zu einer zweiten zylindrischen Gleitfläche zur Welle 39 gepaart, die zusammen eine zweite spielfreie, aber reibungsarme Drehlagerung für die Welle 39 bilden, vergleiche Figuren 8 und 9.

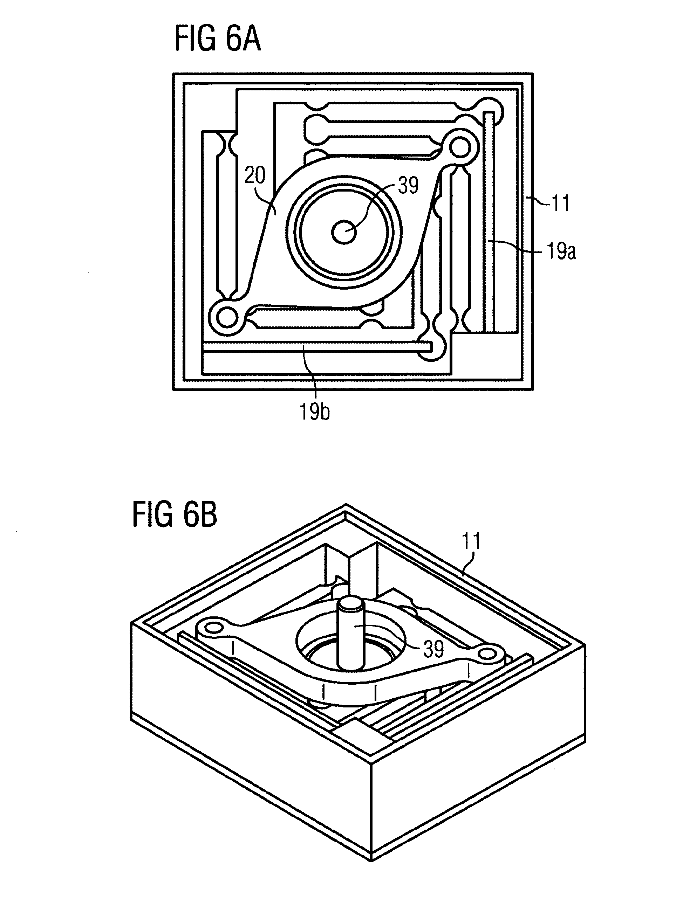

Figur 6 zeigt einen Teilzusammenbau des erfindungsgemäßen Schrittantriebs mit im Gehäuserahmen 11 eingesetztem Bodenelement, eingesetzten Aktoren 19a, 19b, eingesetzten Abstandhaltern 20 und eingesetzter Welle 39.
Figur 7 zeigt eine geeignete Bügelfeder 103. Sie enthält eine Bohrung 30 zum Durchtritt der Wellenachse, wodurch sichergestellt wird, dass diese im Betrieb nicht 'Auswandern' kann. Die Bügelfeder 103 stützt sich über Flächen 31 nahe der Bohrungsachse in Form einer Berührungslinie auf der Welle 39 ab, um ein durch Reibung erzeugtes Bremsdrehmoment auf die Welle 39 möglichst klein zu halten. Die weit außen liegenden unteren Flächen 32 dienen zur Abstützung der Bügelfeder 103 auf einer Deckelfläche. Die Kraft der Bügelfeder 103 ist hinreichend bemessen, um die Welle 39 in allen Betriebszuständen sicher auf Anlage mit der Stirnfläche 27 des Lagerblocks 28 des Bodenelementes zu halten, aber auch möglichst klein gehalten, um nennenswerte Reibungskräfte, die die Drehung der Welle 39 behindern würden zu vermeiden. Auf diese Weise wird sichergestellt, dass die Abrollflächen von Antriebsring 1 und Welle 39 unter allen Betriebsbedingungen hinreichend genau in z-Richtung zueinander lokalisiert bleiben.
Figur 8 zeigt eine geeignete Welle 39. Sie besitzt zwei zylindrische Gleitlagerflächen 33, 34, die mit den zylindrischen Innenflächen der Lagerbohrungen 29, 26 gepaart sind, und mindestens eine zylindrische Abrollfläche 35, die mit mindestens einer Abrollfläche 105 der Ringbohrung 2 des Antriebsringes 1 gepaart ist. Die axiale Verlängerung der Fläche 33 dient zum Anschluss des jeweiligen, vom Schrittmotor anzutreibenden Elementes an die Welle 39.
Figur 9 zeigt einen axialen Querschnitt entlang der z-Achse durch den Antrieb im zusammengebauten Zustand. Sie zeigt insbesondere die Lage seiner Bestandteile zueinander. Die Welle 39 ist an zwei Stellen in Form enger Spielpassungen anhand der Gleitflächenpaare 33, 101 und 34, 102 um die z-Achse reibungsarm drehbar, aber mechanisch steif gegenüber Translation gelagert. Eine geeignete Bügelfeder 103 hält im Zusammenwirken mit der Anlagefläche 27 die Welle 39 bezüglich der z-Richtung reibungsarm fixiert. Das Antriebsmodul hält im Ruhezustand die Abrollfläche 105 der Ringbohrung 2 sowohl konzentrisch als auch in z-Richtung in geeigneter Lage relativ zur Abrollfläche 35 der Welle 39.

Mit Hilfe geeigneter elektrischer Ansteuerfunktionen vollziehen die Biegeaktoren 19a, 19b jeweils an ihrem bewegten Ende Auslenkungen mit sinus- bzw. kosinusförmigen zeitlichem Verlauf um die Ruhelage, wodurch die Abrollfläche 105 der Ringbohrung 2 auf Anlage mit der Abrollfläche 35 der Welle 39 gehalten und in Form einer kreisförmigen Verschiebebewegung um die Abrollfläche 35 der Welle 39 bewegt wird und dadurch die Welle 39 in Rotation versetzt. Mittels der relativen Phasenlage der x- bzw. y-Auslenkungen des Antriebsringes 1 wird die Drehrichtung festgelegt und mit Hilfe der Steuerfrequenz die Drehgeschwindigkeit.

Im einfachsten Fall erfolgt die Kraftübertragung vom Antriebsring 1 auf die Welle 39 durch Reibung. Dabei kann es in Abhängigkeit vom auf die Welle 39 wirkenden Lastdrehmoment eines derartig aufgebauten Stellantriebs zu Schlupf kommen, wodurch die Genauigkeit des Stellantriebs reduziert wird. Der Schlupf wird vorzugsweise durch die Einführung eines Formschlusses zwischen den Abrollflächen von Antriebsring 1 und Welle 39 verringert, insbesondere indem auf die Innenfläche 105 des Antriebsrings 1 und auf die Außenfläche 35 der Welle 39 eine Verzahnung aufgebracht wird. Dabei weisen Antriebsring 1 und Welle 39 vorzugsweise eine Zahndifferenz von mindestens eins auf. Das bedeutet, dass die Verzahnung der Innenfläche 105 des Antriebsrings 1 mindestens einen Zahn mehr als die Außenfläche 35 der Welle 39 umfasst. Werden Antriebsring 1 und Welle 39 innerhalb des Stellantriebs derart betrieben, dass die Verzahnung nicht außer Eingriff gerät, arbeitet der Stellantrieb idealerweise schlupffrei.

Als besonders bevorzugt wird eine zykloidische Verzahnung von Antriebsring 1 und Welle 39 angesehen. Bei der zykloidischen Verzahnung ist nahezu die Hälfte aller Zähne im Eingriff, wodurch ein hohes Drehmoment zwischen Antriebsring 1 und Welle 39 übertragbar ist. Über die Anzahl der auf der Innenfläche 105 des Antriebsrings 1 und der Außenfläche 35 der Welle 39 befindlichen Zähne ist zunächst eine Untersetzung des Stellantriebs festgelegt, die typischerweise in einem Bereich von 20:1 bis 200:1 liegt. Um den Stellantrieb um nur einen Zahn weiter zu stellen, das heißt die Welle 39 durch den Antriebsring 1 um einen Zahn weiter zu drehen, muss vorzugsweise eine vollständige Periode des ansteuernden Sinussignals des Stellantriebs durchlaufen werden. Da zum Weiterstellen um einen Zahn ein Zyklus des Ansteuersignals durchlaufen werden muss, zeichnet sich der Stellantrieb durch eine hohe Genauigkeit und durch eine hohe Wiederholgenauigkeit aus. Zudem wird über die Anzahl der Zähne und die Nutzung von einem Zyklus des Ansteuersignals pro Zahn eine hohe Winkelauflösung des Stellantriebs realisiert. Ergänzend dazu kann beliebig innerhalb einer Periode des Ansteuersignals interpoliert werden, um einen Mikroschrittbetrieb des Stellantriebs zu gewährleisten. Somit liefert der Stellantrieb gemäß bevorzugter Konstruktionen eine hohe Effizienz, eine hohe Untersetzung, ein hohes übertragbares Drehmoment basierend auf der Verzahnung von Antriebsring 1 und Welle 39, Schlupffreiheit bei der Übertragung des Drehmoments, eine beliebige Interpolation des Drehwinkels innerhalb eines Zahns der Welle 39 (Mikroschrittbetrieb), geringe Antriebsdrehmomentschwankungen (Ripple) und eine niedrige Zahnflankenbelastung für Antriebsring 1 und Welle 39, so dass ebenfalls der Verschleiß reduziert wird.

## Patentansprüche

1. Elektromechanischer Motor, insbesondere piezoelektrischer Mikroschrittantrieb, aufweisend:
- zwei elektromechanische Antriebselemente (19a, 19b), die annähernd senkrecht zueinander ausgerichtete Wirkrichtungen aufweisen,
- eine in einem Antriebsring (1) derart drehbar gelagerte Welle (39), dass der Antriebsring (1) durch eine Auslenkung der elektromechanischen Antriebselemente (19a, 19b) in die jeweilige Wirkrichtung zu einer unmittelbar auf die Welle (39) übertragbaren Verschiebebewegung anregbar ist, so dass die Welle (39) im Antriebsring (1) abrollt und **dadurch** rotiert, während
- am Antriebsring (1) zwei bezüglich der beiden Wirkrichtungen diagonal gegenüberliegende Befestigungen (3a, 3b) vorgesehen sind, anhand derer der Antriebsring (1) über jeweils ein annähernd rechtwinkliges Winkelelement (36a, 36b), dessen Schenkel (5a, 5b, 9a, 9b) jeweils zu ihren beiden Enden hin jeweils ein Gelenk aufweisen, an jeweils einem Fixierelement (12, 14) flexibel aufgehängt ist,
- **dadurch gekennzeichnet, dass** die Winkelelemente (36a, 36b), deren vier Schenkel (5a, 5b, 9a, 9b) sich um den Antriebsring (1) herum zu einer annähernd rechtwinklig ausgebildeten, parallel zu den beiden Wirkrichtungen ausgerichteten Umrahmung ergänzen, so angeordnet sind, dass die jeweilige Befestigung (3a, 3b) mittels des jeweiligen Winkelelements (36a, 36b) an ein ihr in der Umrahmung diagonal gegenüberliegend angeordnetes Fixierelement (12, 14) angebunden ist,
- und wobei die Winkelelemente (36a, 36b) jeweils ein Eckelement (7a, 7b) aufweisen, deren Abstand zueinander mittels einer Zwangsmaßnahme konstant gehalten ist, so dass der Antriebsring (1) verschiebbar, aber nicht tordierbar aufgehängt ist.

2. Elektromechanischer Motor nach Anspruch 1, bei dem parallel zur Ebene des Antriebsringes (1) mindestens ein als Stab oder Bügel ausgebildeter Abstandhalter (20) angeordnet ist, dessen Enden starr mit den Eckelementen (7a, 7b) der Winkelelemente (36a, 36b) verbunden sind.

3. Elektromechanischer Motor nach Anspruch 2, bei dem die Eckelemente (7a, 7b) mindestens einseitig jeweils einen senkrecht zur Ebene des Antriebsringes (1) angeordneten Zapfen (7.1, 7.2) aufweisen, und bei dem der Abstandhalter (20), dessen Enden jeweils mittels einer Durchgangsbohrung (21) mit dem jeweiligen Zapfen (7.1, 7.2) des jeweiligen Eckelementes (7a, 7b) verbindbar sind, eine Ausnehmung (23) für die berührungsfreie Durchführung der vom Antriebsring (1) angetriebenen Welle (39) aufweist.

4. Elektromechanischer Motor nach Anspruch 1 bis 3, bei dem die Schenkel (5a, 5b, 9a, 9b) der Winkelelemente (36a, 36b) jeweils mittels jeweils eines Festkörpergelenks (4a, 4b, 6a, 6b, 8a, 8b, 10a, 10b) an die Befestigung (3a, 3b), das Eckelement (7a, 7b) und an das Fixierelement (12, 14) angebunden sind.

5. Elektromechanischer Motor nach Anspruch 4, bei dem die Festkörpergelenke (4a, 4b, 6a, 6b, 8a, 8b, 10a, 10b) jeweils durch eine Querschnittsverjüngung der Schenkel (5a, 5b, 9a, 9b) der Winkelelemente (36a, 36b) in einem kurzen Abschnitt gebildet sind.

6. Elektromechanischer Motor nach einem der Ansprüche 1 bis 5, bei dem die Fixierelemente (12, 14) in diagonal gegenüberliegenden Ecken eines annähernd rechteckigen mechanisch steifen Rahmens (11) befestigt sind.

7. Elektromechanischer Motor nach Anspruch 6, bei dem der Rahmen (11) als ein Gehäuseteil des Schrittantriebs ausgebildet ist.

8. Elektromechanischer Motor nach einem der Ansprüche 1 bis 7, dessen zwei elektromechanische Antriebselemente (19a, 19b) Biegewandler, vorzugsweise piezoelektrische Biegewandler, sind.

9. Elektromechanischer Motor nach Anspruch 8, bei dem die Biegewandler (19a, 19b) jeweils über einen an ihr bewegtes Ende angekoppelten, annähernd parallel zur Wirkrichtung des zugehörigen Biegewandlers angeordneten Zug-Druckstab (17a, 17b) an den Antriebsring (1) angelenkt sind, wobei die Zug-Druckstäbe (17a, 17b) jeweils zu jedem ihrer beiden Enden hin ein Festkörpergelenk (16a, 16b, 18a, 18b) aufweisen, und bei dem jeweils ein Biegewandler (19a, 19b) und der zugehörige Zug-Druckstab (17a, 17b) über Eck entlang zweier Seiten (38) oder Hälften des Antriebsringes (1) angeordnet sind.

10. Elektromechanischer Motor nach Anspruch 8, bei dem der Antriebsring (1), die Winkelelemente (36a, 36b) und die Fixierelemente (12, 14) ein einstückig in Kunststoffspritzgusstechnik gefertigtes Antriebsmodul bilden, wobei die Biegewandler (19a, 19b) mit in das Antriebsmodul eingespritzt sind.

11. Elektromechanischer Motor nach einem der Ansprüche 1 bis 10, bei dem ein annähernd quaderförmiges Gehäuse mit einem Bodenelement und einem Deckel vorgesehen ist, wobei im Bodenelement ein zentraler Lagerblock (28) mit einer Anlagefläche (27) und mit einer ersten Lagerbohrung (26) und im Deckel eine zweite Lagerbohrung (29) für die Welle (39) vorgesehen ist, und wobei die Fixierelemente (12, 14) derart in einer Gehäuseecke angeordnet und dort befestigt oder integriert sind, dass die mindestens eine zylindrische Abrollfläche (35) der Welle (39) in einer zugehörigen Abrollfläche (105) einer Ringbohrung (2) des Antriebsringes (1) abrollen kann.

12. Elektromechanischer Motor nach Anspruch 11, bei dem die Welle (39) mit einem scheibenförmigen Mittelstück ausgebildet ist, dessen erste ringförmige Stirnfläche auf dem Lagerblock (28) aufliegt und dessen Mantelfläche die zylindrische Abrollfläche (35) der Welle (39) bildet.

13. Elektromechanischer Motor nach Anspruch 12, bei dem zur Sicherstellung der Fixierung in z-Richtung der Achse der Welle (39) eine mit einer Bohrung (30) zum Durchtritt der Welle (39) versehene Bügelfeder (103) vorgesehen ist, die sich einerseits auf der zweiten ringförmigen Stirnfläche des scheibenförmigen Mittelstücks der Welle (39) und andererseits bei aufgesetztem Deckel auf einer Fläche des Deckels so abstützt, dass die Drehung der Welle (39) nicht nennenswert behindert wird.

14. Elektromechanischer Motor nach einem der Ansprüche 1 bis 13, bei dem zur formschlüssigen Kraftübertragung auf die Innenfläche (105) der Ringbohrung (2) des Antriebsringes (1) und auf die zugehörige Abrollfläche (35) der Welle (39) eine Verzahnung, insbesondere eine zykloide Verzahnung, aufgebracht ist.

## Claims

1. Electromechanical motor, especially a piezoelectric microstepper drive, exhibiting:
- two electromechanical drive elements (19a, 19b) which exhibit effective directions aligned approximately perpendicularly to one another,
- a shaft (39) supported rotatably in a drive ring (1) in such a manner that the drive ring (1) can be activated by a deflection of the electomechanical drive elements (19a, 19b) into the respective effective direction to perform a displacement movement which can be transmitted directly to the shaft (39), in such a manner that the shaft (39) rolls in the drive ring (1) and as a result rotates, whilst
- on the drive ring (1), two securing elements (3a, 3b) which are diagonally opposite with respect to the two effective directions are provided by means of which the drive ring (1) is flexibly suspended on in each case one fixing element (12, 14) via in each case an approximately rectangular angle element (36a, 36b), the legs (5a, 5b, 9a, 9b) of which in each case have toward their two ends a hinge,
- **characterized in that** the angle elements (36a, 36b), the four legs (5a, 5b, 9a, 9b) of which complement one another around the drive ring (1) to form an approximately rectangularly constructed frame aligned in parallel with the two effective directions, are arranged in such a manner that the respective securing element (3a, 3b) is linked by means of the respective angle element (36a, 36b) to a fixing element (12, 14) arranged diagonally oppositely to it in the frame,
- and the angle elements (36a, 36b) in each case exhibiting a corner element (7a, 7b), the distance of which with respect to one another is kept constant by means of a mandatory measure so that the drive ring (1) is suspended to be displaceable but not to be twistable.

2. Electromechanical motor according to Claim 1, in which, in parallel with the plane of the drive ring (1), at least one spacer (20) constructed as rod or yoke is arranged, the ends of which are rigidly connected to the corner elements (7a, 7b) of the angle elements (36a, 36b).

3. Electromechanical motor according to Claim 2, in which the corner elements (7a, 7b) exhibit at least on one side in each case one peg (7.1, 7.2) arranged perpendicularly to the plane of the drive ring (1), and in which the spacer (20), the ends of which can be connected in each case by means of a through hole (21) to the respective peg (7.1, 7.2) of the respective corner element (7a, 7b), exhibits a recess (23) for contactlessly passing the shaft (39) driven by the drive ring (1).

4. Electromechanical motor according to Claim 1 to 3, in which the legs (5a, 5b, 9a, 9b) of the angle elements (36a, 36b) are in each case linked to the securing element (3a, 3b), the corner element (7a, 7b) and to the fixing element (12, 14) by means of in each case one flexure hinge (4a, 4b, 6a, 6b, 8a, 8b, 10a, 10b).

5. Electromechanical motor according to Claim 4, in which the flexure hinges (4a, 4b, 6a, 6b, 8a, 8b, 10a, 10b) are in each case formed by a cross-sectional tapering of the legs (5a, 5b, 9a, 9b) of the angle elements (36a, 36b) in a short section.

6. Electromechanical motor according to one of Claims 1 to 5, in which the fixing elements (12, 14) are secured in diagonally opposite corners of an approximately rectangular, mechanically stiff frame (11).

7. Electromechanical motor according to Claim 6, in which the frame (11) is constructed as a housing part of the stepper drive.

8. Electromechanical motor according to one of Claims 1 to 7, the two electromechanical drive elements (19a, 19b) of which are bending actuators, preferably piezoelectric bending actuators.

9. Electromechanical motor according to Claim 8, in which the bending actuators (19a, 19b) are in each case hinged to the drive ring (1) via a compression-tension rod (17a, 17b) arranged approximately in parallel with the effective direction of the associated bending actuator and coupled to their moving end, the compression-tension rods (17a, 17b) in each case exhibiting a flexure hinge (16a, 16b, 18a, 18b) toward each of their two ends and in which in each case one bending actuator (19a, 19b) and the associated compression-tension rod (17a, 17b) are arranged at right angles along two sides (38) or halves of the drive ring (1).

10. Electromechanical motor according to Claim 8, in which the drive ring (1), the angle elements (36a, 36b) and the fixing elements (12, 14) form a drive module fabricated in one piece in plastic injection-molding technique, the bending actuators (19a, 19b) also being injected into the drive module.

11. Electromechanical motor according to one of claims 1 to 10, in which an approximately cuboidal housing with a floor element and a lid is provided, a central bearing block (28) with a support surface (27) and with a first bearing bore (26) being provided in the floor element and a second bearing bore (29) for the shaft (39) being provided in the lid and the fixing elements (12, 14) being arranged in a housing corner and secured or integrated there in such a manner that the at least one cylindrical rolling area (35) of the shaft (39) can roll in an associated rolling area (105) of an annular bore (2) of the drive ring (1).

12. Electromechanical motor according to Claim 11, in which the shaft (39) is constructed with a disk-shaped centerpiece, the first annular front face of which rests on the bearing block (28) and the surface area of which forms the cylindrical rolling area (35) of the shaft (39).

13. Electromechanical motor according to Claim 12, in which, to secure the fixing in the z direction of the axis of the shaft (39), a yoke spring (103) provided with a hole (30) for the passage of the shaft (39) is provided which is supported, on the one hand, on the second annular front face of the disk-shaped centerpiece of the shaft (39) and, on the other hand, with the lid in place, on an area of the lid in such a manner that the rotation of the shaft (39) is not significantly impeded.

14. Electromechanical motor according to one of Claims 1 to 13, in which, for the form-locked transmission of force to the inner area (105) of the annular bore (2) of the drive ring (1) and to the associated rolling area (35) of the shaft (39), a toothing, especially a cycloidal toothing, is applied.

## Revendications

1. Moteur électromécanique, notamment micro-servomoteur piézoélectrique pas à pas, comportant:
- deux organes électromécaniques de commande (19a, 19b) ayant des directions effectives de travail approximativement perpendiculaires l'une par rapport à l'autre,
- un arbre (39) monté en rotation dans une bague de commande (1) de manière telle que la bague de commande (1) peut être sollicitée, par un déplacement des organes électromécaniques de commande (19a, 19b) dans leur direction respective de travail, pour exécuter un glissement pouvant être transmis directement à l'arbre (39), si bien que l'arbre (39) pivote dans la bague de commande (1) et, de cette façon, tourne, alors que,
- sur la bague de commande (1), il est prévu deux fixations (3a, 3b) se faisant face diagonalement par rapport aux deux directions effectives de travail, à l'aide desquelles la bague de commande (1) est suspendue d'une façon souple, par l'intermédiaire de deux organes angulaires (36a, 36b) approximativement rectangulaires dont les branches (5a, 5b, 9a, 9b) comportent chacune une articulation vers leurs deux extrémités, à deux éléments de fixation (12, 14),
**caractérisé par le fait que**
- les organes angulaires (36a, 36b), dont les quatre branches (5a, 5b, 9a, 9b) se complètent pour former, autour de la bague de commande (1), un encadrement approximativement rectangulaire orienté parallèlement aux deux directions effectives de travail, sont disposés de manière telle que la fixation respective (3a, 3b) est liée, au moyen de l'organe angulaire respectif (36a, 36b), à un élément de fixation (12, 14) qui est disposé diagonalement à l'opposé de cette fixation dans l'encadrement,
- et où les organes angulaires (36a, 36b) comportent chacun un élément angulaire (7a, 7b) dont l'écartement l'un par rapport à l'autre est maintenu constant par une contrainte, si bien que la bague de commande (1) est suspendue en translation, mais pas en torsion.

2. Moteur électromécanique selon la revendication 1, dans lequel est disposé, parallèlement au plan de la bague de commande (1), au moins un support d'écartement (20) formé par une tige ou un étrier dont les extrémités sont liées d'une façon rigide aux éléments angulaires (7a, 7b) des organes angulaires (36a, 36b).

3. Moteur électromécanique selon la revendication 2, dans lequel les éléments angulaires (7a, 7b) comportent chacun, au moins d'un côté, un pivot (7.1, 7.2) disposé perpendiculairement au plan de la bague d'entraînement (1) et dans lequel le support d'écartement (20), dont les extrémités peuvent être liées, au moyen d'un alésage traversant (21), au pivot correspondant (7.1, 7.2) de l'élément angulaire (7a, 7b) respectif, comporte un évidement (23) pour laisser passer sans contact l'arbre (39) entraîné par la bague de commande (1).

4. Moteur électromécanique selon les revendications 1 à 3, dans lequel chacune des branches (5a, 5b, 9a, 9b) des organes angulaires (36a, 36b) est liée au moyen d'une articulation respective en corps solide (4a, 4b, 6a, 6b, 8a, 8b, 10a, 10b) à la fixation (3a, 3b), à l'élément angulaire (7a, 7b) et à l'élément de fixation (12, 14).

5. Moteur électromécanique selon la revendication 4, dans lequel les articulations en corps solide (4a, 4b, 6a, 6b, 8a, 8b, 10a, 10b) sont chacune formées par un amincissement sur une courte longueur de la section transversale des branches (5a, 5b, 9a, 9b) des organes angulaires (36a, 36b).

6. Moteur électromécanique selon l'une des revendications 1 à 5, dans lequel les éléments de fixation (12, 14) sont fixés dans des coins diagonalement opposés d'un cadre (11) approximativement rectangulaire et mécaniquement rigide.

7. Moteur électromécanique selon la revendication 6, dans lequel le cadre (11) est réalisé en tant que partie du carter du servomoteur pas à pas.

8. Moteur électromécanique selon l'une des revendications 1 à 7, dont les deux organes électromécaniques de commande (19a, 19b) sont des convertisseurs de flexion, d'une façon préférentielle, des convertisseurs de flexion piézoélectriques.

9. Moteur électromécanique selon la revendication 8, dans lequel les convertisseurs de flexion (19a, 19b) sont articulés sur la bague de commande (1), chacun par l'intermédiaire d'une tige de traction et compression (17a, 17b) couplée par son extrémité mobile et approximativement parallèle à la direction effective de travail du convertisseur de flexion correspondant, les tiges de traction et compression (17a, 17b) comportant une articulation en corps solide (16a, 16b, 18a, 18b) vers chacune de leurs deux extrémités et dans lequel un convertisseur de flexion (19a, 19b) et la tige de traction et compression (17a, 17b) correspondante sont disposés en diagonale le long de deux côtés (38) ou moitiés de la bague de commande (1).

10. Moteur électromécanique selon la revendication 8, dans lequel la bague de commande (1), les organes angulaires (36a, 36b) et les éléments de fixation (12, 14) forment un module d'entraînement fabriqué en une seule pièce en moulage par injection de matière plastique, les convertisseurs de flexion (19a, 19b) étant également moulés par injection dans le module d'entraînement.

11. Moteur électromécanique selon l'une des revendications 1 à 10, pour lequel il est prévu un boîtier approximativement parallélépipédique avec un élément de base et un couvercle, où il est prévu pour l'arbre (39), dans l'élément de base, un bloc support centralisé (28) avec une surface d'appui (27) et un premier alésage de roulement (26) et, dans le couvercle, un deuxième alésage de roulement (29) et où les éléments de fixation (12, 14) sont disposés dans un coin du boîtier et y sont fixés ou intégrés de manière telle que la au moins une surface cylindrique de roulement (35) de l'arbre (39) peut tourner dans une surface de roulement (105) correspondante d'un alésage annulaire (2) de la bague de commande (1).

12. Moteur électromécanique selon la revendication 11, dans lequel l'arbre (39) est conçu avec une partie centrale en forme de disque dont la première surface annulaire de tranche s'applique sur le bloc support (28) et dont la surface de révolution forme la surface cylindrique de roulement (35) de l'arbre (39).

13. Moteur électromécanique selon la revendication 12, dans lequel, pour protéger la fixation dans la direction z de l'axe de l'arbre (39), il est prévu un ressort en anse de panier (103) doté d'un trou (30) pour laisser passer l'arbre (39), ledit ressort en anse de panier s'appuyant, d'une part, sur la deuxième surface annulaire de tranche de la partie centrale en forme de disque de l'arbre (39) et, d'autre part, lorsque le couvercle est en place, sur une surface du couvercle de manière telle que la rotation de l'arbre (39) n'est pas gênée d'une façon sensible.

14. Moteur électromécanique selon l'une des revendications 1 à 13, dans lequel, pour la transmission des forces par embrayage, un engrenage, et notamment un engrenage cycloïdal, est ménagé sur la surface intérieure (105) de l'alésage annulaire (2) de la bague de commande (1) et sur la surface de roulement (35) correspondante de l'arbre (39).
